# EUROPÄISCHE PATENTSCHRIFT

(11) **EP 0 790 541 B1**
(45) Veröffentlichungstag und Bekanntmachung des Hinweises auf die Patenterteilung: **25.06.2003**
(21) Anmeldenummer: 97100383.5
(22) Anmeldetag: 11.01.1997
(51) Int. Cl.: G05B 19/042, H02J 13/00, H05K 7/14

(54) **Anschlusseinrichtung für ein elektrisches Installationssystem**
Connecting arrangement for an electrical installation system
Dispositif de connexion pour un système d'installation électrique

(30) Priorität: 16.02.1996 DE 19605698
(43) Veröffentlichungstag der Anmeldung: 20.08.1997
(73) Patentinhaber: Wieland Electric GmbH, 96052 Bamberg (DE)
(72) Erfinder: Rusche, Dieter, Dipl.-Ing., 96049 Bamberg (DE); Strack, Holger, Dipl.-Ing., 96047 Bamberg (DE); Tschirwitz, Ulrich, Dipl.-Phy.-Dr., 96949 Bamberg (DE); Wölfel, Dieter, 91301 Forchheim (DE); Ziegmann, Miachel, Dipl.-Ing., 96052 Bamberg (DE)
(74) Vertreter: Matschkur, Lindner Blaumeier Patent- und Rechtsanwälte

(56) Entgegenhaltungen:
- EP-A- 0 559 163
- US-A- 4 558 914
- US-A- 4 790 762
- US-A- 5 475 583

## Beschreibung

Die Erfindung betrifft eine Anschlußeinrichtung für ein elektrisches Gebäudeinstallationssystem zur Steuerung von Verbrauchern und/oder zur Weiterleitung von Meldesignalen über eine eine externe Bus-Leitung bildende Datenleitung mit serieller digitaler Datenübertragung, wobei die Steuer- und/oder Meldeinformationen von und zur externen Bus-Leitung über eine busteilnehmerseitige Bus-Ankopplung geleitet wird, mit einem die Bus-Ankopplung enthaltenden Basismodul und nachgeschalteten funktionsspezifischen Erweiterungsmodulen mit digitalen und/oder analogen Eingängen und/oder Ausgängen für die jeweiligen Verbraucher, die mit dem Basismodul kommunizierend intern verbunden sind.

Im Rahmen der modernen Elektroinstallation haben sich mittlerweile Systeme, die für die Daten- und Signalübertragung und damit für die Verbrauchersteuerung eine im Gebäude geführte Bus-Leitung verwenden, durchgesetzt. Dabei werden sog. "intelligente" Verbraucher verwendet, in welchen jeweils eine eigene Bus-Ankopplung integriert ist. Wird nun mittels eines Schalters, der ebenfalls über einen eigenen Bus-Koppelstein in die Bus-Leitung eingeschaltet ist, ein Signal auf den Bus gegeben, so kann jedes Gerät mittels seiner Bus-Kopplung das für ihn spezifische Signal auswählen, d.h., jede verbraucherseitige Busankopplung wird mit dem Signal definiert angesprochen und somit der Verbraucher bedient. Nachteilig hierbei ist, daß die Verbraucher selbst infolge der vorzusehenden Bus-Ankopplung gegenüber normalen Verbrauchern sehr viel teurer sind.

Aus der DE-42 00 818 A1 oder aus der Druckschrift der Fa. Wieland: WIB Wieland Installations Bus, Druckvermerk 0054. 1Mü 9.92 ist ein Verteiler, der in eine Bus-Leitung eingeschaltet wird und mit eigenen Bus-Ankopplungen, denen entsprechende Schaltglieder nachgeschaltet sind, bekannt. Bei diesem System analysieren die Bus-Koppler die vom Gebäude-Bus zugeführten Signale und schalten die ihnen nachgeschaltete Schalteinrichtung, beispielsweise ein Relais, entsprechend. Es wird bei diesem System folglich keine Bus-Leitung mehr direkt an den Verbraucher geführt, so daß dieser auch nicht mit der teuren Bus-Ankopplung ausgerüstet sein muß. Vielmehr wird der Verbraucher direkt mit der Lastleitung bedient. Nachteilig bei diesem System aber ist, daß der Verteiler im Hinblick auf die vielen möglichen auszuführenden oder ausführbaren Funktionen viel zu groß zu dimensionieren ist, um diese gänzlich zu umfassen. Daneben muß im Rahmen der Nachrüstung stets ein neuer, kompletter Verteiler verwendet werden, was ebenfalls sehr kostenintensiv ist.

Ferner ist aus der DE-40 19 465 A1 eine Anschlußeinrichtung bekannt, die aus einem die Bus-Ankopplung aufweisenden Basismodul besteht, an welches funktionsspezifische Erweiterungsmodule, die auf verbraucherspezifische Funktionen ausgelegt sind, angeschlossen werden. Der Aufbau dieser Einrichtung ist dabei derart, daß ausgehend von dem Basismodul jeweils eine eigene Kommunikationsleitung zu jedem Erweiterungsmodul geführt ist. Mittels dieser erfolgt die Kommunikation zwischen den jeweiligen Modulen, wobei die Datenerkennung und modulspezifische Weiterleitung mittels eines im Basismodul integrierten Mikroprozessors erfolgt. Die Funktion der einzelnen Module selbst ist aber nachteiligerweise durch die Vorprogrammierung des Mikroprozessors fest vorgegeben. Der Einsatz ist damit auf diese vorbestimmten Funktionen begrenzt. Die Erweiterungsmodule stellen lediglich ausführende Untereinheiten dar, da sie lediglich die ausführenden Komponenten, die spezifisch vom einzigen, in seiner Kapazität begrenzten Mikroprozessor angesprochen werden, sind. Femer ist, da der Mikroprozessor mit seinen vorgegebenen Anschlußmöglichkeiten jeweils mit je einem Erweiterungsmodul verbunden ist, die maximale Anzahl der anschließbaren Module begrenzt. Weiterhin ist nachteilig, daß für jedes Erweiterungsmodul eine separate Kommunikationsleitung vorzusehen ist, was Schwierigkeiten hinsichtlich einer möglichst kleinen Dimensionierung bereitet. Darüber hinaus ist eine Erweiterung nach Festinstallation - sofern diese im Hinblick auf die von den Anschlußmöglichkeiten des Prozessors vorgegebene geringe maximale Modulanzahl überhaupt möglich ist - infolge der fest installierten Kommunikationsleitungen nicht oder sehr umständlich möglich, da entweder eine neue Leitung an den Prozessor direkt gelegt werden muß, oder aber, sofern nicht genutzte "Leerleitungen" durch die Module geführt werden, diese erst umständlich verlängert oder zumindest umständlich in der in der DE 40 19 465 A1 beschriebenen Form angeschlossen werden müssen.

Aus US 4 790 762 A ist ein Steckmodul für eine programmierbare Steuerung offenbart, welche Steuerung an die speziellen Anforderungen im Bereich der Fabrikautomation angepaßt ist. Die dort beschriebene Anschlußeinrichtung dient zur Steuerung von Verbrauchern bzw. zur Weiterleitung von Meldesignalen über eine Datenleitung mit serieller digitaler Datenübertragung und umfaßt ein Basismodul und nachgeschaltete funktionsspezifische Erweiterungsmodule.

Aus US 5 475 583 A ist eine speicherprogrammierbare Steuerung, insbesondere für Verpackungs- und Etikettiermaschinen bekannt, bei der es auf eine sehr schnelle Datenübertragung im Megaherzbereich ankommt, um sehr schnelle Steuerungsvorgänge zu bewältigen. Auch bei dieser Anschlußeinrichtung ist ein Basismodul zur Busankopplung vorgesehen, dem Erweiterungsmodule nachgeschaltet sind, in denen jeweils ein separater Mikrokontroller zur Verwaltung der Steuerinformation vorgesehen ist.

Aus US 4 558 914 A ist ein mit einem zentralen Prozessor verbindbares Input-/Output-Modul zur Bildung einer Maschinensteuerung zum Empfang von Informationen und zum Ausgeben von Steuerbefehlen an externe Vorrichtungen beschrieben, das mit einem bereits maschinenseitig vorgesehenen Input-/Output-Modul verbindbar ist, wozu geeignete Verbindungsmöglichkeiten an den jeweiligen Gehäusen vorgesehen sind.

Schließlich ist aus EP 0 559 163 A ist eine programmierbare Steuerung bekannt, die es ermöglicht, Input-/Output-Module auf einfache Weise im On-line-Mode benutzerseitig auszutauschen.

Der Erfindung liegt somit das Problem zugrunde, eine Anschlußeinrichtung zu schaffen, die in ihrem Aufbau wesentlich vereinfacht ist, so daß Verbesserungen sowohl hinsichtlich der Funktionalität als auch in kostenmäßiger, fertigungstechnischer und dimensionierungstechnischer Hinsicht erzielt werden können.

Zur Lösung dieses Problems ist bei einer Anschlußeinrichtung der eingangs genannten Art erfindungsgemäß vorgesehen, daß das Basismodul einen der Bus-Ankopplung (BCU) nachgeschalteten Basis-Mikrocontroller enthält, an den eine durch alle Erweiterungsmodule hindurchgeführte interne Bus-Leitung zur Übertragung von Steuer- und/oder Meldeinformationen angeschlossen ist, welche mittels jeweils in den Erweiterungsmodulen angeordneten Erweiterungsmodul-Mikrocontrollern verarbeitet werden, und daß das Basismodul an eine parallel zur externen Bus-Leitung verlaufende Leistungsleitung ankoppelbar ist, die durch das Basismodul und die Erweiterungsmodule hindurch geführt ist, und die im angekoppelten Zustand die Leistungsversorgung für angeschlossene Verbraucher liefert.

Vorteilhafte Weiterbildungen sind in den Unteransprüchen angegeben.

Bei der erfindungsgemäßen Anschlußvorrichtung ist damit nur eine einzige durch sämtliche Module durchgeführte Modul-Bus-Leitung vorgesehen, über welche der komplette Datentransfer von und zu den Verbrauchern bzw. der externen Bus-Leitung erfolgt. Damit können an das Basismodul - natürlich abhängig von der Kapazität des Basis-Mikrocontrollers - insoweit beliebig viele Erweiterungsmodule angeschlossen werden, ohne daß irgendwelche Schwierigkeiten in fertigungstechnischer Hinsicht auftreten, da eben keine zusätzlichen und separaten Kommunikationsleitungen durchzuführen sind. Eine beliebige Erweiterung ist bei den bisher bekannten Anschlußeinrichtungen ohnehin nicht möglich, da die Erweiterbarkeit auf die in dem Basismodul vorkonfektionierten maximalen Kommunikationsleitungen begrenzt ist. Durch das Zusammenwirken des Basis-Mikrocontrollers, der die von der Datenleitung abgenommenen Daten bezüglich ihrer Wertigkeit hinsichtlich der spezifischen Erweiterungsmodule aufbereitet, und der Erweiterungsmodul-Mikrocontroller kann somit mit besonderem Vorteil eine problemlose und funktionsgenaue Kommunikation zwischen den einzelnen Mo dulen gewährleistet werden.

Da in zunehmendem Maße die externe Bus-Leitung von Haus aus parallel zu einer gebäudeseitigen Leistungsleitung geführt ist, ist das Basismodul an die parallel zur externen Bus-Leitung geführte Leistungsleitung ankoppelbar, welche durch das Basismodul und die Erweiterungsmodule hindurchgeführt ist. Durch diese erfindungsgemäße Ausbildung wird somit erreicht, daß mit der Anschlußeinrichtung nicht nur die Schaltsignale zu den jeweiligen Verbrauchern geführt werden, die im einfachsten Falle bereits selbst eine eigene Leistungsversorgung besitzen, sondern daß hier auch die Leistungsversorgung zu den Verbrauchern mit durch die Anschlußeinrichtung geführt wird.

Die interne Bus-Leitung umfaßt im einfachsten Falle eine 2-Draht-Leitung, wobei jede Datenleitung für einen unidirektionalen seriellen Datentransfer geeignet ist. Parallel dazu ist eine Versorgungsleitung für die Mikrocontroller und die Elektronik der Erweiterungsmodule durchgeführt, die das Bezugspotential liefert. Im Rahmen einer erfindungsgemäßen Weiterbildung kann zur weiteren Vereinfachung des Aufbaus vorgesehen sein, daß die interne Bus-Leitung eine 1-Draht-Leitung ist, auf welcher die Daten vorteilhaft bidirektional seriell geführt werden.

Um eine möglichst einfache und sichere Verbindung sowohl zwischen der externen Bus-Leitung und der Bus-Ankopplung als auch zwischen den Modulen selbst zu realisieren, kann in weiterer Erfindungsausgestaltung vorgesehen sein, daß die jeweiligen Kopplungen und/oder die internen Modulverbindungen als vorzugsweise kodierte Steckverbindungen ausgebildet sind, wobei insbesondere die ggf. vorgesehene Kodierung die Sicherheit im Hinblick auf eine zulässige Modulkopplung erhöht. Dabei kann erfindungsgemäß zur Verringerung etwaiger Einzelkomponenten vorgesehen sein, daß die Bus-Ankopplung und die Ankopplung an die Leistungsleitung in Form einer Kombinationssteckverbindung realisiert sind, so daß lediglich eine einzelne Steckverbindung konfektioniert werden muß. Im gleichen Maße vorteilhaft ist es, wenn die modulinterne Bus-Leitungs- und Leistungsleitungsankopplung in Form einer derartigen Kombinationssteckverbindung realisiert ist.

Da mittels der erfindungsgemäßen Anschlußeinrichtung auch eine bauliche Verbesserung insbesondere in dimensionierungstechnischer Hinsicht erzielbar ist, kann insbesondere mittels der Kombinationssteckverbindung bereits eine ausreichende mechanische Verbindung zwischen den Einzelmodulen hergestellt werden. Jedoch hat es sich als zweckmäßig herausgestellt, wenn, wie erfindungsgemäß ferner vorgesehen ist, das Basismodul und die Erweiterungsmodule zusätzlich miteinander lösbar verrastbar sind, so daß auch von ihrem "Innenleben" her schwere Module sicher verbunden werden können. Die Verrastung sollte natürlich einfachst lösbar sein im Hinblick auf eine Vereinfachung des Anschlusses, was beispielsweise dadurch realisiert sein kann, daß die Verrastung bereits von Hand oder mittels eines Werkzeuges wie eines Schraubenziehers betätigbar ist.

Um insbesondere im Falle der Nachrüstung sich an bereits bestehende Anschlußeinrichtungen undloder bauliche Gegebenheiten anpassen zu können, kann in weiterer Erfindungsausgestaltung vorgesehen sein, daß die Module untereinander über eine ggf. steckbare Verlängerungsleitung miteinander verbindbar sind. Dies ist dahingehend von besonderem Vorteil, daß so ein Erweiterungsmodul auch an einer zu der bereits bestehenden Anschlußeinrichtung dezentralen Stelle angeordnet werden kann und trotzdem eine sichere Kommunikation realisierbar ist. Die Verlängerungsleitung beinhaltet in diesem Fall natürlich die von Modul zu Modul durchgeschleiften Leitungen, nämlich zum einen die interne Bus-Leitung, und zum anderen ggf. die Leistungsversorgung.

Um auch den Anschluß der Einzelverbraucher an die Erweiterungsmodule möglichst einfach und sicher zu ermöglichen, kann erfindungsgemäß ferner vorgesehen sein, daß die den Erweiterungsmodulen zugeordneten Verbraucher mittels vorzugsweise kodierten Steckverbindungen an die Eingänge und/oder Ausgänge anschließbar sind, wobei auch diese Steckverbindungen natürlich untereinander verrastbar sein können. Die Eingänge und/oder Ausgänge der jeweiligen Module können dabei erfindungsgemäß bezüglich des Modulgehäuses nach innen versetzt sein.

Da auch die basismodulseitige Bus-Ankopplung einen wenngleich niedrigen Energiebedarf hat, ist eine entsprechende Leistungsversorgung vorgesehen. Dies kann erfindungsgemäß dadurch realisiert sein, daß sie über die externe Bus-Leitung mit Energie versorgt wird und von der nachgeschalteten Modulelektronik vorzugsweise mittels Optokoppler galvanisch getrennt ist, so daß Signalstörungen, bedingt durch die Modulelektronik, auf diese Weise vermieden werden und eine sichere Datenkommunikation zwischen externer Bus-Leitung und Bus-Ankopplung möglich ist.

Da ferner sowohl die Elektronik des Basismoduls als auch die der Erweiterungsmodule einen gewissen Energiebedarf haben, ist in weiterer Erfindungsausbildung ein im Basismodul angeordnetes, ggf. über die Leistungsleitung versorgtes Hilfsnetzteil vorgesehen, das sowohl die Elektronik des Basismoduls als auch die Elektronik der Erweiterungsmodule über die interne Bus-Leitung mit Energie versorgt. Alternativ dazu kann gemäß einer weiteren Erfindungsalternative das Hilfsnetzteil lediglich die Elektronik des Basismoduls versorgen, die Versorgung der Erweiterungsmodule erfolgt durch eine erweiterungsmodulinterne Ankopplung an die hindurchgeführte Leistungsleitung, wobei in diesem Fall natürlich eine entsprechende Aufbereitung zu erfolgen hat, da an der Leistungsleitung vorzugsweise Drehstrom anliegt.

Ferner kann erfindungsgemäß vorgesehen sein, daß am Basismodul und/oder den jeweiligen Erweiterungsmodulen eine von außen zugängliche Einstelleinrichtung, vorzugsweise ein Schalter, zur Adressierung des jeweiligen Moduls angeordnet ist, um auf diese Weise eine eindeutige Datenzuordnung sicherstellen zu können. Um für Servicezwecke eine Bedienbarkeit des jeweiligen Moduls und damit des nachgeschalteten Verbrauchers auch ohne Ansteuerung durch die Gebäude-Bus-Leitung zu ermöglichen, kann in weiterer Erfindungsausgestaltung vorgesehen sein, daß mittels der Einstelleinrichtung das jeweilige Modul wahlweise außer Betrieb oder in Dauerbetrieb bringbar ist, um auf diese Weise seine Funktionstüchtigkeit zu überprüfen. Daneben oder alternativ dazu kann eine am Basismodul und/oder jedem Erweiterungsmodul vorgesehene weitere Einstelleinrichtung angeordnet sein, vorzugsweise in Form eines Tastschalters, mittels welcher das jeweilige Modul wahlweise außer Betrieb oder in Dauerbetrieb bringbar ist.

Um eine korrekte basismodulseitige Datenaufbereitung und -zuordnung zu den Einzelmodulen zu gewährleisten, ist - wie bereits beschrieben - die Adressierung der Einzelmodule vorgesehen. Um eine weitere "Sicherheitsstufe" diesbezüglich zu realisieren, ist mit besonderem Vorteil erfindungsgemäß ferner vorgesehen, daß der in den Erweiterungsmodulen befindliche Mikrocontroller durch eine Kodierung auf seine für das jeweilige Modul erforderliche funktionsspezifische Eigenschaft voreingestellt ist und der damit festgelegte Typ des Erweiterungsmoduls über die interne Bus-Leitung an das Basismodul übermittelt wird. Somit stehen quasi zwei Kontrollmechanismen für eine richtige Zuordnung zur Verfügung, nämlich einmal die Adresse selbst und zum anderen das "Moduleigenschaftssignal", die beide vom Basismodul-Mikrocontroller zur Überprüfung der Richtigkeit der Datenzuordnung aufgenommen und ausgewertet werden, wobei bei einem festgestellten Fehler (wenn also die Adresse und/oder das Moduleigenschaftssignal mit dem Datenformat nicht übereinstimmt) eine Fehlermeldung an die Schaltzentrale gegeben wird und/oder am jeweiligen Modul direkt angezeigt wird.

Ausführungsbeispiele der Erfindung werden nachfolgend anhand der Zeichnungen näher beschrieben. Dabei zeigen:
- Fig. 1: eine perspektivische Ansicht einer Anschlußeinrichtung, bestehend aus einem Basismodul und 4 Erweiterungsmodulen, in schematischer Form,
- Fig. 2: drei Ansichten (2a, 2b, 2c) des Basismoduls,
- Fig. 3: zwei Ansichten (3a, 3b) eines Erweiterungsmoduls,
- Fig. 4: eine Schaltskizze des Basismoduls aus Fig. 2,
- Fig. 5: eine Schaltskizze des Erweiterungsmoduls aus Fig. 3, und
- Fig. 6 bis 8: Schaltskizzen verschiedener Erweiterungsmodule.

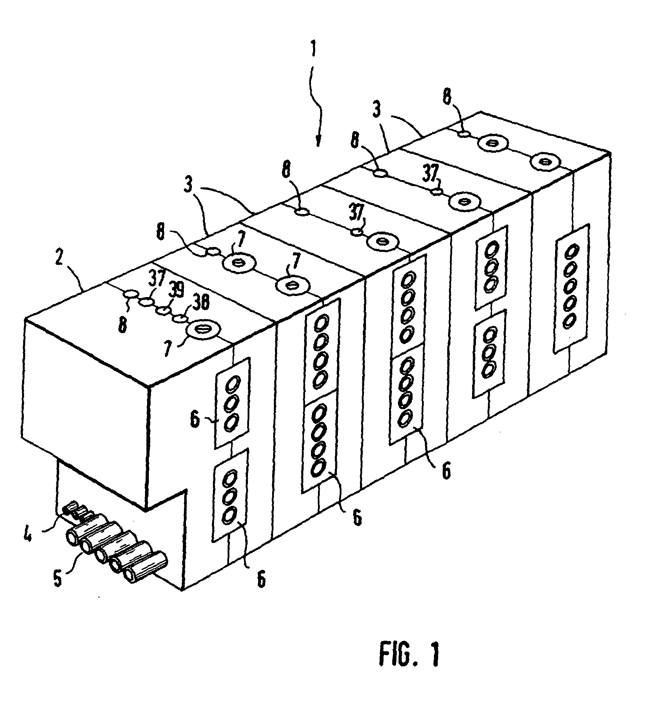

Fig. 1 zeigt eine zusammengesteckte Anschlußeinrichtung 1, bestehend aus einem Basismodul 2 und verschiedenen, in ihren Funktionen hier nicht näher spezifizierten Erweiterungsmodulen 3. Das Basismodul 2 weist einen Steckanschluß 4 zur Verbindung mit der externen Bus-Leitung und einen Anschluß 5 zur Ankopplung an die parallel zur externen Bus-Leitung geführte Leistungsversorgung auf. Jedes der Module 2 und 3 besitzt diverse digitale und/oder analoge Eingänge und/oder Ausgänge 6, wobei deren Funktion natürlich abhängig von den erweiterungsmodulspezifischen Eigenschaften ist. Wie Fig. 1 ferner zu entnehmen ist, besitzt in diesem Fall auch das Basismodul 2 derartige Anschlußmöglichkeiten. Gezeigt sind ferner die oberseitig angeordneten, als beispielsweise mittels eines Schraubendrehers od.dgl. betätigbare Drehschalter ausgebildeten Einstelleinrichtungen 7, mittels welcher die Module 2, 3 funktionsspezifisch adressiert werden können. Ferner sind entsprechende Signaleinrichtungen 8 an den einzelnen Modulen vorgesehen, mittels welcher der Status des Moduls oder etwaige Fehlermeldungen visualisiert werden können. Gezeigt sind ferner moduleigene Einstelleinrichtungen in Form von Tastschaltern 37, mit denen die jeweiligen Module zu Simulationszwecken manuell betätigbar sind, wobei die Tastschalter im gezeigten Beispiel lediglich an den Modulen mit mindestens einem Ausgang vorgesehen sind. Das Basismodul 2 besitzt ferner noch eine weitere Tastereinrichtung 38 zum physikalischen Programmieren des Basismoduls bezüglich der Adresse für die über die externe Bus-Leitung geführten Signale, wobei der Tastereinrichtung 38 eine Anzeigeleuchte 39 zugeordnet ist, die beispielsweise dann leuchtet, wenn die Programmierung noch nicht erfolgt ist und nach Durchführung derselben erlischt.

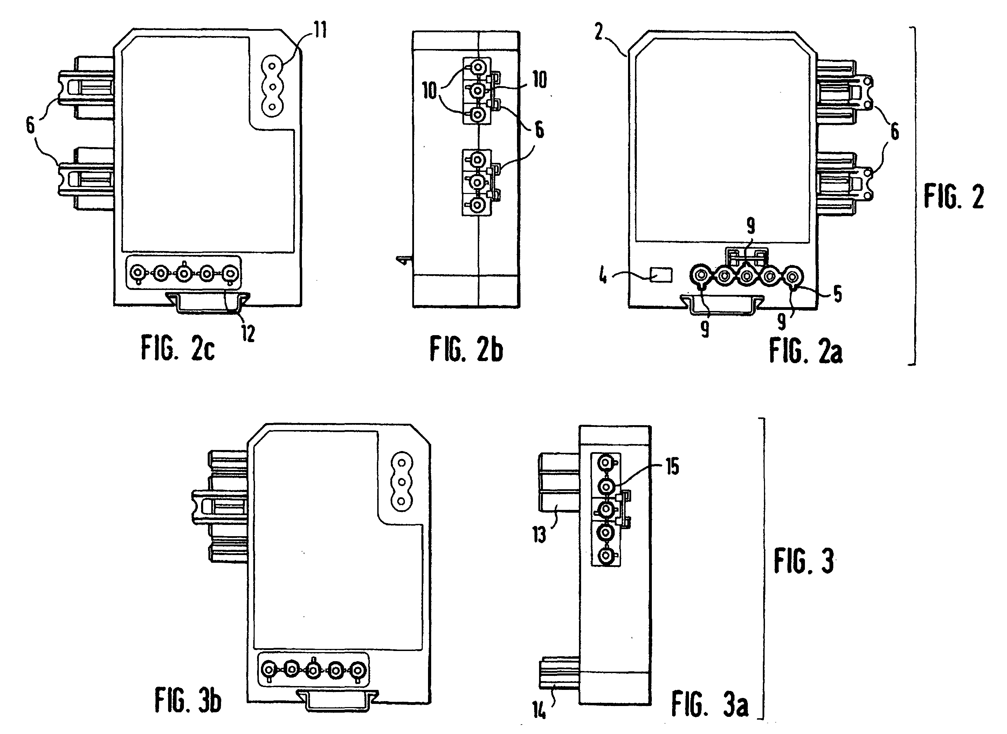

Fig. 2 zeigt in drei Ansichten eine konkrete Realisationsform des Basismoduls 2. In der in Fig. 2a gezeigten Seitenansicht ist die Seite des Basismoduls 2 dargestellt, an welcher die Kopplung an die externe Bus-Leitung und die Leistungsversorgung erfolgt. Neben dem Anschluß 4 an die externe Bus-Leitung ist der 5-polige Anschluß 5 im Detail dargestellt. Insbesondere ist die mittels der Nasen 9 realisierte Kodierung zu erkennen, die eine fehlerhafte Steckverbindung verhindert. Fig. 2b zeigt das Basismodul in um 90° gedrehter Stellung mit Aufsicht auf die Ausgänge 6. Auch hier sind an den Ausgängen Kodierausnehmungen 10 vorgesehen. Schließlich zeigt Fig. 2c die andere Seite des Basismoduls 2. Gezeigt ist zum einen der ebenfalls als Steckverbindung ausgeführte Anschluß 11 für die modulinterne Daten-Bus-Leitung, zum anderen die Steckverbindung 12 für die Leistungsleitung, die ja ebenfalls durch die Einzelmodule durchgeführt ist. Auch dies ist in entsprechender Weise kodiert.

In Fig. 3 ist nun ein erstes Anschlußmodul 3 dargestellt, das dem Basismodul 2 aus Fig. 2 direkt nachschaltbar ist. Zu diesem Zweck weist das Erweiterungsmodul 3 einen Stecker 13 auf, der zur Verbindung mit der Steckaufnahme 11 des Basismoduls dient und über den der modulinterne Datenbus in das Erweiterungsmodul 3 durchgeführt wird. Ferner ist ein Stecker 14 vorgesehen, der zur Verbindung mit der Aufnahme 12 des Basismoduls 2 dient und mittels dem so die Leistungsversorgung durchgeschleift wird. Beide Stecker 13 und 14 sind selbstverständlich entsprechend der zugeordneten Aufnahmen 11, 12 kodiert, wie insbesondere Fig. 3b zu entnehmen ist. Gezeigt ist ferner die funktionsspezifische Anschlußmöglichkeit 15 dieses Moduls, bei der es sich um insgesamt vier verschiedene Eingänge handelt, mit denen verbraucherseitige Daten empfangen werden können.

Abgesehen von der Ausbildung der jeweiligen funktionsspezifischen Anschlußmöglichkeit ist der Aufbau jedes der Erweiterungsmodule 3 im Hinblick auf die Ausbildung der Steckaufnahmen 11 und 12 und der Steckanschlüsse 13 und 14 gleich, so daß die Reihenfolge der aufgesteckten Module keine Rolle spielt bzw. die Erweiterungsmodule unabhängig von ihrer Funktion untereinander austauschbar sind. Sollte eine bestimmte Reihenfolge bevorzugt werden, so ist eine unterschiedliche Kodierung der Steckverbinder denkbar.

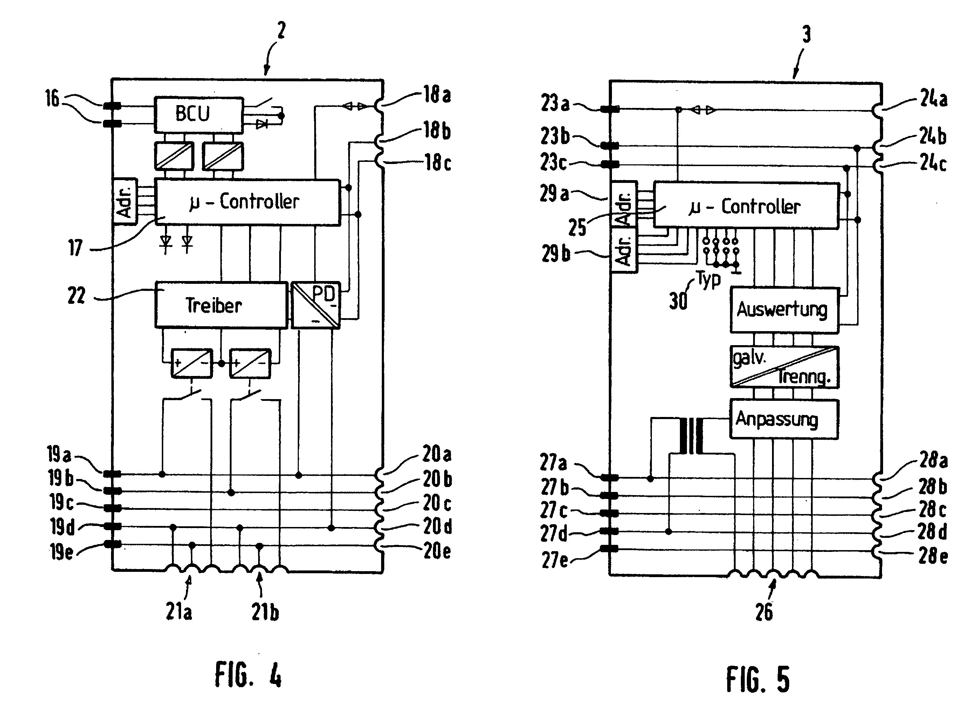

Fig. 4 zeigt eine Schaltskizze des Aufbaus des Basismoduls 2. Mit 16 ist die zweiadrige Leitung der externen Bus-Leitung gekennzeichnet, über welche die Datenzufuhr führt. Der daran angekoppelten Bus-Ankopplung (BCU) ist der Mikrocontroller 17 nachgeschaltet, der den gesamten Datenfluß von und zu der externen Datenleitung steuert und die Daten entsprechend aufbereitet. Gezeigt ist ferner die modulinterne Bus-Leitung, die hier aus den drei Leitungen 18a, b und c besteht, wobei die Leitung 18a dem Datentransfer dient und die Leitungen 18b und c die Versorgungsleitung für die Mikrocontroller und die Elektronik der Erweiterungsmodule darstellen, die das Bezugspotential liefert. Im unteren Modulbereich ist die eingehende Leistungsversorgung dargestellt. Diese besteht im gezeigten Beispiel aus den Leitungen 19a bis 19e, wobei über die Leistungsleitungen 19a bis c der Drehstrom eingespeist wird, die Leitung 19d den Nulleiter und die Leitung 19e den Schutzleiter darstellen. Sämtliche Leitungen werden an der gegenüberliegenden Seite des Moduls wieder herausgeführt und enden in den jeweiligen Steckkontakten 20a bis 20e. Darüber hinaus ist das in Fig. 4 gezeigte Basismodul mit zwei Ausgängen 21a, 21b ausgestattet, über welche von den Leitungen 19a und 19b abgenommene Leistung dem nachgeschalteten Verbraucher zugeführt werden kann, wie der Schaltskizze zu entnehmen ist. Zu diesem Zweck ist ein Treiber 22 vorgesehen, der vom Mikrocontroller aus gesteuert wird und der ihm nachgeschaltete Steuerschalter betätigt, um die Leistung entsprechend zu schalten.

Fig. 5 zeigt den Schaltplan eines Erweiterungsmoduls, wie es in Fig. 3 in seiner konkreten Ausführung dargestellt ist. Oberseitig sind drei Steckkontakte 23a, 23b und 23c vorgesehen, die beim Anschließen an das Basismodul 2 in die Steckaufnahmen 18a bis c, die den internen Modulbus realisieren, eingeführt werden und so den Modulbus weiterführen. Die drei Einzelleitungen werden durch das Erweiterungsmodul 3 hindurchgeführt und treten an der anderen Seite an den Steckaufnahmen 24a, 24b, 24c wieder aus. Mit der Datenleitung des Steckkontakts 23a ist ein Mikrocontroller 25 verbunden, mittels welchem die über die Leitung geführten, dem spezifischen Erweiterungsmodul 3 zugeordneten Daten abgegriffen werden bzw., wie in diesem Fall, der Datenleitung zugeführt werden, da es sich bei dem in Fig. 5 dargestellten Modul um ein Eingabemodul handelt, mit dem Signale von den Verbrauchern kommend der externen Bus-Leitung zugeführt werden, wozu die Anschlüsse 26, an welchen der Verbraucher angekoppelt ist, dienen. Auch hier sind im unteren Modulteil fünf Stecker 27a bis 27e ausgebildet, die ihr Komplementärstück in den Steckaufnahmen 20a bis 20e des Basismoduls finden. Auch sie treten an den Steckaufnahmen 28a bis 28e an der gegenüberliegenden Seite wieder aus. Gezeigt sind ferner zwei Schalter 29a, 29b, die zum Einstellen der Adresse des spezifischen Erweiterungsmoduls 3 bzw. in diesem Fall des jeweiligen Eingangspaares 26 dienen, da das beschriebene Modul zwei separate Eingangspaare, die auch separat adressierbar sind, besitzt. Gezeigt ist ferner eine Einrichtung 30, mittels welcher der Mikrocontroller selbst in seiner spezfischen Funktion kodiert ist. Dieses hierdurch erzeugbare Kodiersignal wird auf die Datenleitung gegeben, um auf diese Weise im Rahmen eines Feedbacks zum Mikrokontroller 17 des Basismoduls 2 eine weitere Sicherheitskontrolle im Hinblick auf die Datenaufbereitung und -zuordnung zu realisieren.

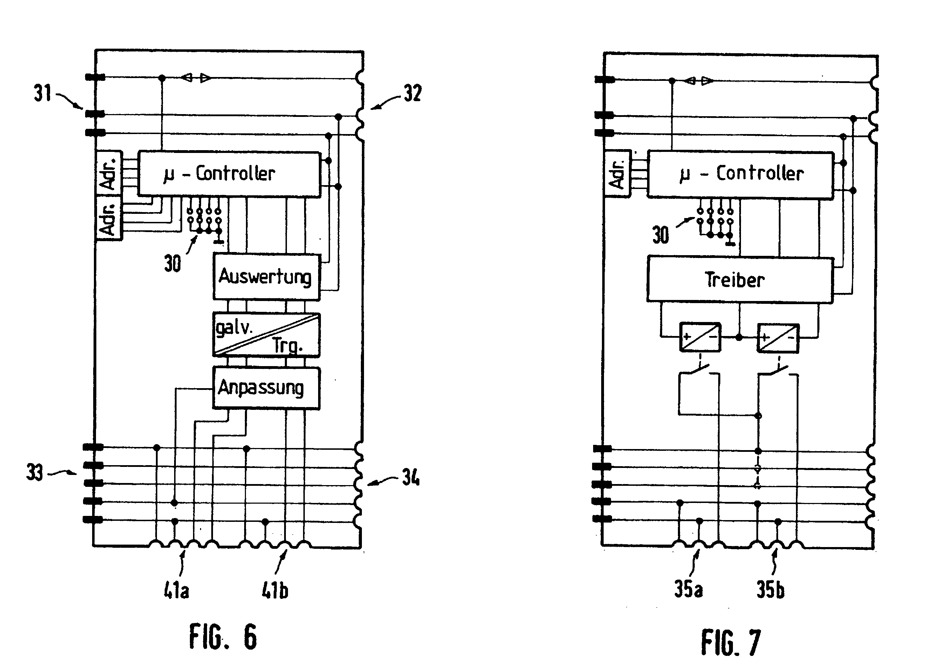

Eine weitere Ausführungsform eines Erweiterungsmoduls ist in Fig. 6 dargestellt. Auch hier sind entsprechende Stecker 31 und gegenüberliegende Steckaufnah - men 32 angeordnet, mittels denen der modulinterne Datenbus weitergeführt wird. Gleiches gilt für die entsprechenden Stecker und Aufnahmen 33, 34 bezüglich der durchgeschleiften Leistungsversorgung. Das Modul entspricht im weiteren Aufbau hinsichtlich der Adressierungsschalter und des Mikrocontrollers weitestgehend dem aus Fig. 5, da auch dieses Modul ein Eingabemodul mit zwei separaten Eingangspaaren 41a, 41b ist, jedoch mit einer Schaltspannung von 230 Volt arbeitet, wohingegen das in Fig. 5 gezeigte Modul mit einer Schaltspannung von lediglich 24 Volt arbeitet.

Eine weitere Realisation eines Erweiterungsmoduls ist in Fig. 7 dargestellt. Dieses Modul weist - neben dem ansonsten modultypischen Aufbau - zwei Ausgänge 35a, 35b auf, mit denen eine Spannung von 230 Volt, wie sie über die Leistungsversorgung als Drehstrom geliefert wird, zur Verfügung gestellt wird. Durch dieses Modul können beispielsweise Leuchtstofflampen oder Halogenlampen od.dgl. geschaltet werden.

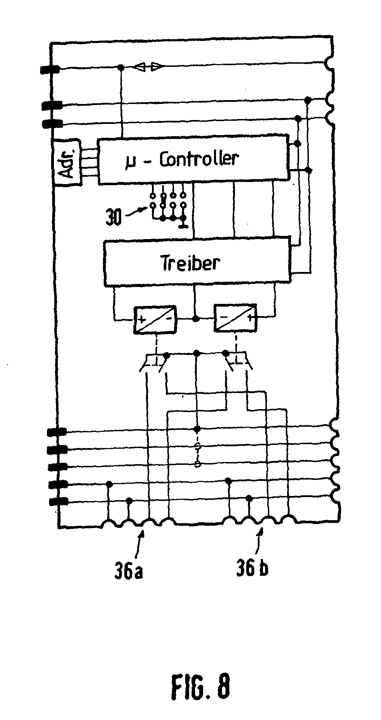

Eine weitere Modulrealisation ist ferner in Fig. 8 dargestellt. Dieses Modul stellt zwei Ausgänge 36a, 36b mit einer Spannung von 230 Volt zur Verfügung, die im gezeigten Fall gleichlaufend sind. Mit diesem Modul kann beispielsweise ein Jalousiemotor geschaltet werden.

## Patentansprüche

1. Anschlußeinrichtung für ein elektrisches Gebäudeinstallationssystem zur Steuerung von Verbrauchern und/oder zur Weiterleitung von Meldesignalen über eine eine externe Bus-Leitung (16) bildende Datenleitung mit serieller digitaler Datenübertragung, wobei die Steuer- und/oder Meldeinformationen von und zur externen Bus-Leitung (16) über eine busteilnehmerseitige Bus-Ankopplung (BCU) geleitet wird, mit einem die Bus-Ankopplung (BCU) enthaltenden Basismodul (2) und nachgeschalteten funktionsspezifischen Erweiterungsmodulen (3) mit digitalen und/oder analogen Eingängen (26; 41a, 41b) und/oder Ausgängen (21a, 21b; 35a, 35b; 36a, 36b) für die jeweiligen Verbraucher, die mit dem Basismodul (2) kommunizierend intern verbunden sind, **dadurch gekennzeichnet, daß** das Basismodul (2) einen der Bus-Ankopplung (BCU) nachgeschalteten Basis-Mikrocontroller (17) enthält, an den eine durch alle Erweiterungsmodule (3) hindurchgeführte interne Bus-Leitung (18a, 23a, 24a) zur Übertragung von Steuer- und/oder Meldeinformationen angeschlossen ist, welche mittels jeweils in den Erweiterungsmodulen (3) angeordneten Erweiterungsmodul-Mikrocontrollern (25) verarbeitet werden, und daß das Basismodul (2) an eine parallel zur externen Bus-Leitung verlaufende Leistungsleitung ankoppelbar ist (19a - 19e), die durch das Basismodul (2) und die Erweiterungsmodule (3) hindurch geführt ist, und die im angekoppelten Zustand die Leistungsversorgung für angeschlossene Verbraucher liefert.

2. Anschlußeinrichtung nach Anspruch 1, **dadurch gekennzeichnet, daß** die Interne Bus-Leitung eine 1-Draht-Leitung ist.

3. Anschlußeinrichtung nach einem der vorangehenden Ansprüche, **dadurch gekennzeichnet, daß** die jeweiligen Kopplungen und/oder die internen Modulverbindungen als Steckverbindungen ausgebildet sind.

4. Anschlußeinrichtung nach Anspruch 3, **dadurch gekennzeichnet, daß** die Steckverbindungen als kodierte Steckverbindungen ausgeführt sind.

5. Anschlußeinrichtung nach einem der Ansprüche 3 oder 4, **dadurch gekennzeichnet, daß** die Bus-Ankopplung und die Ankopplung an die Leistungsleitung in Form einer Kombinationssteckverbindung realisiert ist.

6. Anschlußeinrichtung nach einem der Ansprüche 3 bis 5, **dadurch gekennzeichnet, daß** die modulinteme Bus-Leitungs- und Leistungsleitungskopplung in Form einer Kombinationssteckverbindung realisiert ist.

7. Anschlußeinrichtung nach einem der Ansprüche 3 bis 6, **dadurch gekennzeichnet, daß** das Basismodul (2) und die Erweiterungsmodule (3) zusätzlich miteinander lösbar verrastbar sind.

8. Anschlußeinrichtung nach einem der vorangehenden Ansprüche, **dadurch gekennzeichnet, daß** das Basismodul (2) und die Erweiterungsmodule (3) untereinander über eine ggf. steckbare Verlängerungsleitung miteinander verbindbar sind.

9. Anschlußeinrichtung nach einem der vorangehenden Ansprüche, **dadurch gekennzeichnet, daß** Verbraucher mittels weiterer Steckverbindungen an die Eingänge und/oder Ausgänge (21a, 21b, 26, 35a, 35b, 36a, 36b) des Basismoduls (2) bzw. der Erweiterungsmodule (3) anschließbar sind.

10. Anschlußeinrichtung nach Anspruch 9, **dadurch gekennzeichnet, daß** die weiteren Steckverbindungen als kodierte Steckverbindungen ausgeführt sind.

11. Anschlußeinrichtung nach einem der vorangehenden Ansprüche, **dadurch gekennzeichnet, daß** die basismodulseitige Bus-Ankopplung über die externe Bus-Leitung mit Energie versorgt wird und von den nachgeschalteten Erweiterungsmodulen (3) galvanisch getrennt ist.

12. Anschlußeinrichtung nach Anspruch 11, **dadurch gekennzeichnet, daß** zum galvanischen Trennen ein Optokoppler vorgesehen ist.

13. Anschlußeinrichtung nach einem der vorangehenden Ansprüche, **dadurch gekennzeichnet, daß** ein ggf. über die Leistungsleitung versorgtes, im Basismodul angeordnetes Hilfsnetzteil sowohl die Elektronik des Basismoduls als auch die Elektronik der Erweiterungsmodule über die interne Bus-Leitung mit Energie versorgt.

14. Anschlußeinrichtung nach Anspruch 13, **dadurch gekennzeichnet, daß** das Hilfsnetzteil lediglich die Elektronik des Basismoduls versorgt und die Versorgung der Elektronik der Erweiterungsmodule durch eine modulinterne Ankopplung an die hindurchgeführte Leistungsleitung erfolgt.

15. Anschlußeinrichtung nach einem der vorangehenden Ansprüche, **dadurch gekennzeichnet, daß** am Basismodul (2) und/oder den jeweiligen Erweiterungsmodulen (3) eine von außen zugängliche Einstelleinrichtung (7) zur Adressierung des jeweiligen Moduls (2, 3) angeordnet ist.

16. Anschlußeinrichtung nach Anspruch 15, **dadurch gekennzeichnet, daß** die Einstelleinrichtung (7) als Schalter ausgebildet ist.

17. Anschlußeinrichtung nach Anspruch 15 oder 16, **dadurch gekennzeichnet, daß** mittels der Einstelleinrichtung (7) das jeweilige Modul (2, 3) wahlweise außer Betrieb oder in Dauerbetrieb bringbar ist.

18. Anschlußeinrichtung nach einem der Ansprüche 1 bis 15, **dadurch gekennzeichnet, daß** das Basismodul (2) und/oder jedes Erweiterungsmodul (3) eine bzw. eine weitere Einstelleinrichtung aufweist, mittels welcher das jeweilige Modul (2, 3) wahlweise außer Betrieb oder in Dauerbetrieb bringbar ist.

19. Anschlußeinrichtung nach Anspruch 18, **dadurch gekennzeichnet, daß** die weitere Einstelleinrichtung als Tastschalter (37) ausgebildet ist.

20. Anschlußeinrichtung nach einem der vorangehenden Ansprüche, **dadurch gekennzeichnet, daß** die Erweiterungsmodul-Mikrocontroller (25) durch eine Kodierung (30) auf ihre für das jeweilige Modul (3) erforderliche funktionsspezifische Eigenschaft voreingestellt sind und der damit festgelegte Typ des Erweiterungsmoduls (3) über die interne Bus-Leitung an das Basismodul (2) zur eindeutigen Zuordnung von Funktion und Adresse des einzelnen Erweiterungsmoduls (3) übermittelbar ist.

21. Anschlußeinrichtung nach einem der vorangehenden Ansprüche, **dadurch gekennzeichnet, daß** die Eingänge und/oder die Ausgänge der jeweiligen Module bezüglich der Außenseite des Modulgehäuses nach innen versetzt angeordnet sind.

## Claims

1. Connecting arrangement for an electrical building installation system for controlling consumers and/or passing on alarm signals via a data line forming an external bus line (16) with serial digital data transmission, wherein the control and/or alarm information is passed from and to the external bus line (16) via a bus coupling (BCU) on the bus participant side, having a base unit (2) containing the bus coupling (BCU) and function-specific expansion units (3) connected in series having digital and/or analogue inputs (26; 41a, 41 b) and/or outputs (21a, 21b; 35a, 35b; 36a, 36b) for each user, which are internally communicatingly connected to the base unit (2), **characterised in that** the base unit (2) contains a base microcontroller (17) which is connected downstream of the bus coupling (BCU) and to which an internal bus line (18a, 23a, 24a) passing through all expansion units (3) is connected for the transmission of control and/or alarm information processed by means of expansion unit microcontrollers disposed respectively in the expansion units (3), and **in that** the base unit (2) is couplable (19a-19e) to a power line extending parallel to the external bus line and passing through the expansion units (3), and supplying the power supply for connected consumers in the coupled state.

2. Connecting device according to claim 1, **characterised in that** the internal bus line is a 1-wire line.

3. Connecting device according to one of the preceding claims, **characterised in that** the respective couplings and/or the intemal unit connections are formed as plug connections.

4. Connecting device according to claim 3, **characterised in that** the plug connections are formed as coded plug connections.

5. Connecting device according to one of claims 3 or 4, **characterised in that** the bus coupling and the coupling to the power line takes the form of a combination plug connection.

6. Connecting device according to one of claims 3 to 5, **characterised in that** the bus line and power line coupling inside the unit takes the form of a combination plug connection.

7. Connecting device according to one of claims 3 to 6, **characterised in that** the base unit (2) and the expansion unit (3) are additionally capable of being locked together detachably.

8. Connecting device according to one of the preceding claims, **characterised in that** the base unit (2) and the expansion unit (3) are capable of being connected together via an optionally plug-in extension lead.

9. Connecting device according to one of the preceding claims, **characterised in that** consumers may be connected by means of further plug connections to the inputs and/or outputs (21a, 21b, 26, 35a, 35b, 36a, 36b) of the base unit (2) or of the expansion unit (3).

10. Connecting device according to claim 9, **characterised in that** the further plug connections are formed as coded plug connections.

11. Connecting device according to one of the preceding claims,
**characterised in that** the bus coupling on the base unit is supplied with power via the external bus line and is galvanically separated from the downstream expansion units (3).

12. Connecting device according to claim 11, **characterised in that** for galvanic separation an opto-coupler is used.

13. Connecting device according to one of the preceding claims, **characterised in that** a feeder circuit component optionally supplied via the power line and disposed in the base unit supplies power both to the electronics of the base unit and the electronics of the expansion unit via the internal bus line.

14. Connecting device according to claim 13, **characterised in that** the feeder circuit component only supplies the electronics of the base unit and the supply to the electronics of the expansion units is effected by a coupling inside the unit to the power line passing through.

15. Connecting device according to one of the preceding claims, **characterised in that** a setting device (7) accessible from outside for addressing the respective unit (2, 3) is disposed on the base unit (2) and/or on the respective expansion units (3).

16. Connecting device according to claim 15, **characterised in that** the setting device (7) is formed as a switch.

17. Connecting device according to claim 15 or 16, **characterised in that** by means of the setting device (7) the respective unit (2, 3) can be put selectively out of action or into long-term operation.

18. Connecting device according to one of claims 1 to 15, **characterised in that** the base unit (2) and/or each expansion unit (3) has one or a further setting device, by means of which the respective unit (2, 3) can be put selectively out of action or into long-term operation.

19. Connecting device according to claim 18, **characterised in that** the further setting device is formed as a momentary-contact switch (37).

20. Connecting device according to one of the preceding claims, **characterised in that** the expansion unit microcontrollers (25) are pre-set by a code (30) to their function-specific property necessary for the respective unit (3) and the type of expansion unit (3) thereby established is transmissible via the internal bus line to the base unit (2) for unambiguous association of function and address of the individual expansion unit (3).

21. Connecting device according to one of the preceding claims, **characterised in that** the inputs and/or outputs of the respective units are arranged staggered inwards with respect to the exterior of the unit housing.

## Revendications

1. Dispositif de connexion pour le système d'installation électrique d'un bâtiment en vue du pilotage de la consommation et/ou de la transmission de signaux d'appel par l'intermédiaire d'une ligne de données constituant une ligne bus externe (16), avec transmission de données digitales en série, les informations de pilotage et/ou d'appel étant conduites depuis et vers la ligne bus externe (16) par l'intermédiaire d'un bus de couplage à participation bus latéral (BCU) avec un module de base (2) incluant le bus de couplage (BCU) et des modules d'extension à fonctions spécifiques additionnelles (3) avec des entrées analogiques (26, 41 a, 41 b) et/ou des sorties analogiques (21a, 21b, 35a, 35b, 36a, 36b) pour chacun des consommateurs qui sont connectés en communication interne avec le module de base (2), **caractérisé en ce que** le module de base (2) contient un micro-contrôleur de base (17) additionnel au bus de couplage( BCU) auquel est connectée, allant à tous les modules d'extension (3) une ligne-bus interne (18a, 23a, 24a) en vue du transfert d'informations de pilotage et/ou d'appel, laquelle ligne ligne-bus interne intervient au moyen de chacun des micro-contrôleurs des modules d'extension placés dans les modules d'extension et **en ce que** le module de base (2) peut être couplé à une ligne de charge s'étendant parallèlement à la ligne-bus externe, qui passe par le module de base (2) et les modules d'extension (3) et qui délivre l'alimentation ou la prise en charge à l'état couplé pour les consommateurs connectés.

2. Dispositif de connexion selon la revendication 1, **caractérisé en ce que** la ligne-bus interne est une ligne à un fil.

3. Système de connexion selon l'une des revendications précédente, **caractérisé en ce que** chacun des couplages et/ou chacune des liaisons par module interne sont constituées par des connexions par enfichage.

4. Dispositif de connexion selon la revendication 3, **caractérisé en ce que** les connexions par enfichage sont amenées par des liaisons par enfichage codé.

5. Dispositif de connexion selon l'une des revendications 3 ou 4, **caractérisé en ce que** le couplage par bus et le couplage sur la ligne d'alimentation ou de charge est réalisé sous forme d'une liaison par enfichage combiné.

6. Dispositif de connexion selon l'une des revendications 3 à 5, **caractérisé en ce que** le couplage de la ligne-bus et le couplage de la ligne de charge à module interne sont réalisés sous forme de liaison par enfichage combiné.

7. Dispositif de connexion selon l'une des revendications 3 à 6, **caractérisé en ce que** le module de base et les modules d'extension (3) sont au surplus susceptibles d'être mis au repos par séparation les uns des autres.

8. Dispositif de connexion selon l'une quelconque des revendications précédentes, **caractérisé en ce que** le module de base (2) et les modules d'extension (3) peuvent être connectés les uns avec les autres par l'intermédiaire d'une ligne de prolongation éventuellement enfichable.

9. Dispositif de connexion selon l'une quelconque des revendications précédentes, **caractérisé en ce que** des consommateurs ou utilisateurs peuvent être connectés au moyen d'autres liaisons par enfichage aux entrées et/ou aux sorties (21a, 21b, 26, 35a, 35b, 36a, 36b) du module de base (2) ou des modules d'extension (3).

10. Dispositif de connexion selon la revendication 9, **caractérisé en ce que** les autres liaisons par enfichage sont constituées par des liaisons par enfichage codé.

11. Dispositif de connexion selon l'une quelconque des revendications précédentes, **caractérisé en ce que** le couplage par bus à module latéral est réuni à la source d'énergie par l'intermédiaire de la ligne-bus externe, et est séparé par voie galvanique des modules d'extension additionnels (3).

12. Dispositif de connexion selon la revendication 11, **caractérisé en ce qu'**il est prévu en vue de la séparation galvanique un coupleur optique.

13. Dispositif de connexion selon l'une quelconque des revendications précédentes, **caractérisé en ce qu'**un réseau de secours logé dans le module de base et éventuellement alimenté par la conduite d'alimentation ou de charge ainsi que l'électronique du module de base sont, ainsi que l'électronique du module d'extension, alimentés en énergie par la ligne-bus interne.

14. Dispositif de connexion selon la revendication 13, **caractérisé en ce que** le réseau de secours alimente également l'électronique du module de base et qu'il en résulte l'alimentation de l'électronique des modules d'extension par l'intermédiaire d'un couplage modulaire interne avec la ligne d'alimentation ou de charge qui la traverse.

15. Dispositif de connexion selon l'une quelconque des revendications précédentes, **caractérisé en ce que**, sur le module de base (2) et/ou sur chacun des modules d'extension (3) est monté un dispositif de mise au point actionnable de l'extérieur (7) en vue de l'adressage de chacun des modules (2, 3).

16. Disposition de connexion selon la revendication 15, **caractérisé en ce que** le dispositif de mise au point (7) est construit sous forme d'un commutateur.

17. Dispositif de connexion selon la revendication 15 ou 16, **caractérisé en ce que**, au moyen du dispositif de mise au point (7), chacun des modules (2, 3) peut être amené hors service ou en service permanent.

18. Dispositif de connexion selon l'une quelconque des revendications 1 à 15, **caractérisé en ce que** le module de base (2) et/ou chaque module d'extension (3) présentent un ou plusieurs autres dispositifs de mise au point grâce auxquels chaque module (2, 3) peut être amené hors service ou en service permanent à volonté.

19. Dispositif de connexion selon la revendication 18, **caractérisé en ce que** le dispositif de mise au point supplémentaire est réalisé sous forme d'un commutateur à contact (37).

20. Dispositif de connexion selon l'une quelconque des revendications précédentes, **caractérisé en ce que** le micro-contrôleur du module d'extension (25) est pré-réglé au moyen d'un codeur (30) pour chacune des propriétés spécifiques fonctionnelles nécessaires pour chacun des modules (3) et **en ce que** le type monté à cet effet du module d'extension (3) peut être directement monté sur la ligne-bus interne sur le module de base (2) en vue de l'attribution définie de fonction et d'adresse du module d'extension individuel (3).

21. Dispositif de connexion selon l'une quelconque des revendications précédentes, **caractérisé en ce que** les entrées et/ou les sorties de chacun des modules sont montées décalées vers l'intérieur par rapport à la face externe du boîtier du module.
